# EUROPÄISCHE PATENTSCHRIFT

(11) **EP 1 951 931 B1**
(45) Veröffentlichungstag und Bekanntmachung des Hinweises auf die Patenterteilung: **29.12.2010**
(21) Anmeldenummer: 06830060.7
(22) Anmeldetag: 21.11.2006
(51) Int. Cl.: C23C 16/455

(54) **VERFAHREN ZUM ABSCHEIDEN VON SCHICHTEN IN EINEM CVD-REAKTOR SOWIE GASEINLASSORGAN FÜR EINEN CVD-REAKTOR**
METHOD FOR DEPOSITING LAYERS IN A CVD REACTOR AND GAS INLET ELEMENT FOR A CVD REACTOR
PROCEDE DE DEPOT DE COUCHES DANS UN REACTEUR DE DEPOT CHIMIQUE EN PHASE VAPEUR ET ORGANE D'ENTREE DE GAZ DESTINE A UN REACTEUR DE DEPOT CHIMIQUE EN PHASE VAPEUR

(30) Priorität: 22.11.2005 DE 102005055468
(43) Veröffentlichungstag der Anmeldung: 06.08.2008
(73) Patentinhaber: AIXTRON AG, 52134 Herzogenrath (DE)
(72) Erfinder: KÄPPELER, Johannes, 52146 Würselen (DE)
(74) Vertreter: Rieder, Hans-Joachim
(86) Internationale Anmeldenummer: PCT/EP2006/068712
(87) Internationale Veröffentlichungsnummer: WO 2007/060159

(56) Entgegenhaltungen:
- EP-A- 1 528 122
- EP-A1- 0 683 249
- DE-A1- 10 247 921
- US-A- 5 871 586
- US-A1- 2003 000 924
- US-A1- 2003 098 372
- US-A1- 2004 026 374

## Beschreibung

Die Erfindung betrifft ein Verfahren zum Beschichten ein oder mehrerer Substrate mit einer Schicht, deren Komponenten in Form mindestens zweier Gase mittelst eines Gaseinlassorgans in eine Prozesskammer eingeleitet werden, wobei die Gase jeweils in übereinander angeordnete Kammern des Gaseinlassorgans eingebracht werden und von dort durch Gasaustrittsöffnungen, die in die Prozesskammer münden, in die Prozesskammer eintreten.

Die Erfindung betrifft darüber hinaus ein Gaseinlassorgan eines CVD-Reaktors bzw. einen CVD-Reaktor mit mindestens zwei übereinander angeordneten Kammern von deren unteren Wandung jeweils Gasaustrittsöffnungen ausgehen, die in die Prozesskammer münden zur Zuleitung je eines mittels einer Zuleitung in die Kammern gebrachten Prozessgases in die Prozesskammer, deren Boden von einem drehantreibbaren Substrathalter gebildet ist.

Aus der US 5,871,586 ist ein CVD-Reaktor bekannt, der ein duschkopfartiges Gaseinlassorgan aufweist, womit mehrere Prozessgase in eine Prozesskammer eingeleitet werden. Die Unterseite des Gaseinlassorgans besitzt eine Vielzahl von gleichmäßig über die im Wesentlichen kreisrunde Fläche verteilte Gasaustrittsöffnungen, deren Mündung auf einen unterhalb des Gaseinlassorgans angeordneten Substrathalter weisen. Auf diesem drehangetriebenen Substrathalter liegen in ringförmiger Anordnung um das Drehzentrum verteilt mehrere Substrate, die beschichtet werden sollen. Der Substrathalter kann von unten mittels einer geeigneten Heizung beheizt werden. Das Gaseinlassorgan besitzt mehrere übereinander angeordnete Kammern. Eine untere Kammer bildet eine Kühlmittelkammer, durch welche ein Kühlmittel strömt, um die Unterseite des Gaseinlassorgans auf eine Temperatur zu kühlen, die niedriger ist als die Reaktionstemperatur der aus dem Gaseinlassorgan austretenden Prozessgase. Oberhalb dieser Kühlmittelkammer befinden sich gasdicht voneinander getrennt zwei Kammern, die sich im Wesentlichen über die gesamte rotationssymmetrische Querschnittsfläche des Gaseinlassorgans erstrecken. Jede der beiden Kammern wird mit einem anderen Prozessgas gespeist. Eines der beiden Prozessgase kann ein Hydrid, beispielsweise NH₃, Arsin oder Phosphin sein. Ein anderes Prozessgas ist eine metallorganische Verbindung, so dass auf den Substraten Schichten der Elemente der fünften und dritten oder der zweiten und sechsten Hauptgruppe abgeschieden werden können. Jede der beiden Kammern ist mit Gasaustrittskanälen mit der Unterseite der Prozesskammer verbunden. Auch andere, insbesondere metallorganische Ausgangsstoffe werden verwendet.

Im Stand der Technik wird ein sogenanntes ALD-Verfahren beschreiben. Bei diesem Verfahren werden die beiden Prozessgase nicht gleichzeitig in die Prozesskammer eingeleitet, sondern alternierend. Gegebenenfalls kann zwischen der Einleitung des einen und des anderen Prozessgases ein Spülgas in die Prozesskammer eingeleitet werden. Ziel dieses Verfahrens ist es, abwechselnd im Wesentlichen eine Monolage der einen Komponente, beispielsweise der III- oder II-Komponente abzuscheiden und dann eine Monolage der V- oder VI-Komponente auf dem Substrat abzuscheiden. Mit diesem Verfahren soll eine absolute Homogenität der Schichtdicke erzielt werden.

Aus der DE 100 43 601 A1 ist ein CVD-Reaktor zum Abscheiden von III-V-Schichten auf Substraten bekannt. Dort ragt ein Gaseinlassorgan in eine in einer Horizontalebene liegende Prozesskammer. Das Gaseinlassorgan ragt mit einem gekühlten Körper in das Zentrum der Prozesskammer, deren Boden den Substrathalter bildet. Aus der Unterseite des Gaseinlassorgans strömt ein Hydrid, beispielsweise Arsin oder Phosphin in die Prozesskammer. Es wird dort in die Horizontalrichtung umgeleitet, um in Radialrichtung zu den Substraten zu strömen. Oberhalb dieser Austrittsöffnung ist eine weitere, sich über den gesamten Umfang des Gaseinlassorgans erstreckende Gasaustrittsöffnung vorgesehen, durch welche eine metallorganische Verbindung, beispielsweise TMG, in die Prozesskammer eintritt. Eine weitere Gaseinlassvorrichtung ist in DE 102 47 921 A1 beschrieben.

Die US 2005/0158469 A1 beschreibt einen Showerhead-Reaktor, bei dem die Kammern des Gaseinlassorgans von kammartig angeordneten Kanälen gebildet sind.

Die JP03170675A beschreibt ein Gaseinlassorgan mit zwei übereinander angeordneten Kammern, in welche jeweils mit einer Vielzahl von Austrittsöffnungen mit der zur Prozesskammer hinweisenden Wandung verbunden sind. Die einzelnen Austrittsöffnungen können individuell verschlossen werden.

Bei dem Gaseinlassorgan, welches die US 5,950,925 beschreibt, sind in Radialrichtung verlaufende Gasverteilkanäle vorgesehen, um eine räumlich gleichmäßige Verteilung des Gases zu gewährleisten.

Aus der US 6,800,139 ist ein Gaseinlassorgan bekannt, bei dem mehrere Kammern in einer Ebene in unterschiedlichen Radialabständen zum Zentrum angeordnet sind, so dass durch einen zentralen Bereich der Gasaustrittsfläche eine andere Gaszusammensetzung in die Prozesskammer eingebracht werden kann, als durch einen peripheren Bereich der Gasaustrittsfläche.

Aus der US 4,976,996 ist ein CVD-Reaktor bekannt, bei dem das Prozessgas von einer peripheren Wandung der Prozesskammer in die Prozesskammer eingeleitet wird. Das Prozessgas durchströmt die Prozesskammer in horizontaler Richtung von radial außen zum Zentrum hin. In verschiedene Sektoren der Prozesskammer können unterschiedliche Gase eingeleitet werden. Indem der Substrathalter gedreht werden kann, können die auf dem Substrathalter angeordneten Substrate nacheinander verschiedenen Gasphasen ausgesetzt werden. Die Expositionszeiten können über die Rotationsgeschwindigkeit beeinflusst werden.

EP 1 528 122 A1 beschreibt ein Gaseinlassorgan mit übereinander angeordneten Kammern mit jeweils zugeordneten Gaszuleitungen. Von der unteren Wandung der Kammern gehen Gasaustrittsöffnungen aus, die in die Prozesskammer münden. Der Boden der Prozesskammer wird von einem drehantreibbaren Substrathalter gebildet.

Der Erfindung liegt die Aufgabe zugrunde, das eingangs genannte Verfahren bzw. die eingangs genannte Vorrichtung zur Herstellung von homogenen Schichten weiterzubilden.

Gelöst wird die Aufgabe durch die in den Ansprüchen 1, 4, 13 und 16 angegebene Erfindung, wobei jeder der Ansprüche grundsätzlich eine eigenständige Lösung der Aufgabe darstellt.

Der Verfahrensanspruch sieht zunächst und im Wesentlichen vor, dass zufolge einer besonderen Ausgestaltung des Gaseinlassorgans und einer entsprechenden Teilung der Kammern in mehrere Abteile die umfangsversetzte Einspeisung von verschiedenen Prozessgasen in die Prozesskammer möglich ist. Es ist vorgesehen, dass in unterschiedlichen Umfangsabschnitte der Prozesskammer verschiedene Prozessgase getrennt voneinander einströmen. Die unterhalb des Gaseinlassorgans sich auf einer Kreisbahn drehenden Substrate werden somit abwechselnd den unterschiedlichen Prozessgasen ausgesetzt, so dass eine Art des ALD-Verfahrens möglich ist, ohne einen zyklischen Gaswechsel in der Prozesskammer durchzuführen. Es ist insbesondere vorteilhaft, wenn zwischen den Umfangszonen, die mit den Prozessgasen gespeist werden, Spülzonen vorgesehen sind, in welchen ein Inertgas oder ein anderes Spülgas in die Prozesskammer eingeleitet wird. Es erweist sich auch als vorteilhaft, wenn durch das Zentrum des Gaseinlassorgans ebenfalls ein Spül- oder Inertgas in die Prozesskammer eingeleitet wird. Der Gasfluss der Spülgase ist so eingestellt, dass er gerade ausreicht, um ein Übersprechen der einzelnen Prozessgase zu vermeiden. Gleichwohl ist die Vorrichtung aber in der Lage, auch das gattungsgemäße Verfahren durchzuführen, wenn alle Abteile einer jeden Kammer mit demselben Prozessgas gespeist werden. Dann treten die beiden Prozessgase an jeder Stelle aus der Unterseite des Gaseinlassorgans aus. Es gibt dann keine Zonen, in welchen unterschiedliche Prozessgase in die Prozesskammer eingeleitet werden. Dann können sogar Gasphasenreaktionen zwischen den Reaktanten stattfinden.

Der das Gaseinlassorgan betreffende Anspruch sieht zunächst und im Wesentlichen vor, dass jede der beiden Kammern in mindestens zwei Abteile geteilt sind, und die Abteile der Kammern im Wesentlichen deckungsgleich übereinanderliegen. Auch hier kann vorgesehen sein, dass im Bereich der Trennzone zwischen den Abteilen Spülgasaustrittsöffnungen an der Unterseite des Gaseinlassorgans vorgesehen sind. Um das Spülgas in die Abteile einzuleiten, reicht es aus, kammartig mehrere Öffnungen in Radialrichtung mit einer Spülgaszuleitung zu verbinden. Diese separaten Öffnungen werden dann im Bedarfsfall zur Speisung der Prozesskammer mit Spülgas genutzt, so dass benachbarte Zonen, in welche jeweils unterschiedliche Prozessgase in die Prozesskammer einströmen, von einem Gasvorhang getrennt sind. Es ist aber auch vorgesehen, dass ein Abteil einer der beiden Kammern oder zwei übereinander angeordnete Abteile der beiden Kammern zum Spülgaseinlass in die Prozesskammer genutzt werden. In einer ersten Ausgestaltung der Erfindung ist vorgesehen, dass jede Kammer in zwei Abteile geteilt ist. Die die Abteile trennende Trennwand jeder Kammer liegt dann bevorzugt auf einer Diagonalen durch das kreisscheibenförmige Gaseinlassorgan. Die Trennwände liegen übereinander. Es ist aber auch möglich, die Trennwände, die fluchtend übereinanderliegen, jeweils kreuzförmig oder sternartig anzuordnen. Die Abteile können sich über unterschiedliche Umfangswinkel erstrecken. Es können kleinere und größere Abteile vorgesehen sein. Bevorzugt dienen die einen größeren Umfangswinkel umfassenden Abteile der Einspeisung von Prozessgasen in die Prozesskammer. Die sich nur über einen geringen Umfangswinkel um das Zentrum der Prozesskammer oder um ein zentrales Abteil erstreckenden kleineren Abteile dienen der Einspeisung von Spülgas in die Prozesskammer. Die Drehgeschwindigkeit des Substrathalters ist derartig an den Prozess angepasst, dass beim Durchlaufen des Substrates der Umfangszone eines Abteils, durch welches ein Prozessgas in die Prozesskammer eingeleitet wird, genau eine Monolage einer Komponente auf der Substratoberfläche abgeschieden wird. Das Verfahren eignet sich im Besonderen für die Verwendung von solchen Prozessgasen, die von Hause aus nur einlagig auf der Substratoberfläche kondensieren, also selbstlimitierend wachsen. Das Drehen des Substrathalters hat zur Folge, dass abwechselnd unterschiedliche Komponenten auf dem Substrat abgeschieden werden. Wenn die einzelnen Abteile, durch welche wechselweise die Prozessgase in die Prozesskammer eintreten, von Spülzonen getrennt sind, bleibt den Reaktanten auch genügend Zeit, um miteinander schicht- bzw. kristallbildend zu reagieren.

Das zuvor an einem duschkopfartig gestalteten Gaseinlassorgan beschriebene Konzept lässt sich auch an einem Gaseinlassorgan verwirklichen, wie es die DE 100 43 601 A1 oder die DE 101 53 463 A1 beschreiben. Auch dort sind übereinander angeordnete Kammern vorgesehen. Diese liegen allerdings zwischen Decke und Boden der Prozesskammer. Die beiden Kammern des Gaseinlassorgans werden mittels in Vertikalrichtung verlaufende Gaszuleitungen mit Prozessgas versorgt. Diese Prozessgase treten dann in die jeweiligen, zugeordneten Abteile der einzelnen Kammern, um dann in unterschiedliche Umfangsrichtungen aus dem Gaseinlassorgan in Horizontalrichtung auszutreten. Es sind halbkreisförmige Austrittsöffnungen vorgesehen, die übereinander angeordnet sind. Je nach Anzahl der Abteile können aber auch viertelkreis- oder drittelkreisförmige Austrittsöffnungen vorgesehen sein. Ferner ist es möglich, die Austrittsöffnungen für die voneinander verschiedenen Prozessgase auch durch eine Zone zu trennen, aus der ein Spülgas austritt. Die aus den Austrittsöffnungen austretenden Prozessgase strömen in Radialrichtung durch die Prozesskammer und über die um das Gaseinlassorgan gruppierten Substrate. Durch Gasphasenreaktionen oder durch Oberflächenreaktionen werden kristallbildende Reaktionsprodukte gebildet.

Die Gasmischeinrichtung, mit der die einzelnen Abteile der Kammern mit dem jeder Kammer zugeordneten Prozessgas gespeist werden, besitzt erste Gasdosiereinrichtungen für ein erstes Prozessgas und zweite Gasdosiereinrichtungen für ein zweites Prozessgas. Bei dem ersten Prozessgas kann es sich um eines der oben genannten Metallhydride handeln. Bei dem zweiten Prozessgas kann es sich um eine metallorganische Verbindung handeln. Die Gasmischeinrichtung besitzt eine Umschaltventilanordnung. Mit dieser Umschaltventilanordnung können entweder alle Abteile einer jeden Kammer mit dem jeweils der Kammer zugeordneten Prozessgas gespeist werden. Beispielsweise ist es möglich, alle Abteile der oberen Kammer mit einem Hydrid und alle Abteile der unteren Kammer mit einer metallorganischen Verbindung zu speisen. Das Hydrid und die metallorganische Verbindung werden in der Regel mit einem Trägergas, beispielsweise Wasserstoff oder Stickstoff oder einem Edelgas in die jeweilige Kammer hineingeleitet. Zufolge der Umschaltventilanordnung ist es aber auch möglich, jeweils nur eine Auswahl von Abteilen einer jeden Kammer mit dem der Kammer zugeordneten Prozessgas zu versorgen. Diese, mit dem jeweiligen Prozessgas versorgten Abteile liegen nicht übereinander, sondern liegen umfangsversetzt zueinander. Die übrigen, nicht mit dem Prozessgas versorgten Abteile werden mit einem Spülgas gespeist. Das Spülgas tritt dann zusammen mit der jeweiligen Komponente aus der Unterseite des Gaseinlassorgans in die Prozesskammer. Es bilden sich somit in Umfangsrichtung einander abwechselnde Zonen, in denen unterschiedliche Prozessgase und ggf. nur Spülgase in die Prozesskammer eingeleitet werden.

Ausführungsbeispiele der Erfindung werden nachfolgend anhand beigefügter Zeichnungen erläutert. Es zeigen:
- Fig. 1: die Draufsicht auf ein nicht maßstabsgetreu wiedergegebenes Gas- einlassorgan mit angedeuteten Abteilen 1a, 1b einer Kammer 1, die
- Fig. 2: mit Kanälen 3 mit der Unterseite des Gaseinlassorgans verbunden sind, einen nicht maßstabsgetreuen Schnitt gemäß der Linie II - II in Fig. 1,
- Fig. 3: einen Schnitt gemäß der Linie III - III in Fig. 2,
- Fig. 4: ein einfaches Beispiel einer Gasmischeinrichtung zur Versorgung der Abteile 1a, 1b, 2a, 2b der Kammern 1, 2 des in den Figuren 1 und 2 schematisch dargestellten Gaseinlassorgans,
- Fig. 5: einen nicht maßstabsgetreuen Querschnitt durch die obere Kammer 1 eines Gaseinlassorgans eines zweiten Ausführungsbeispiels,
- Fig. 6: den Schnitt gemäß der Linie VI - VI in Fig. 5,
- Fig. 7: einen Querschnitt durch eine Prozesskammer eines weiteren Aus- führungsbeispiels der Erfindung,
- Fig. 8: einen Schnitt gemäß der Linie VIII - VIII in Fig. 7,
- Fig. 9: eine Darstellung gemäß Fig. 7 eines weiteren Ausführungsbeispiels,
- Fig. 10: einen Schnitt gemäß der Linie X - X in Fig. 9,
- Fig. 11: eine Seitenansicht auf ein Gaseinlassorgan gemäß dem in den Figu- ren 9 und 10 dargestellten Ausführungsbeispiel und
- Fig. 12: einen Schnitt gemäß der Linie XII - XII in Fig. 11.

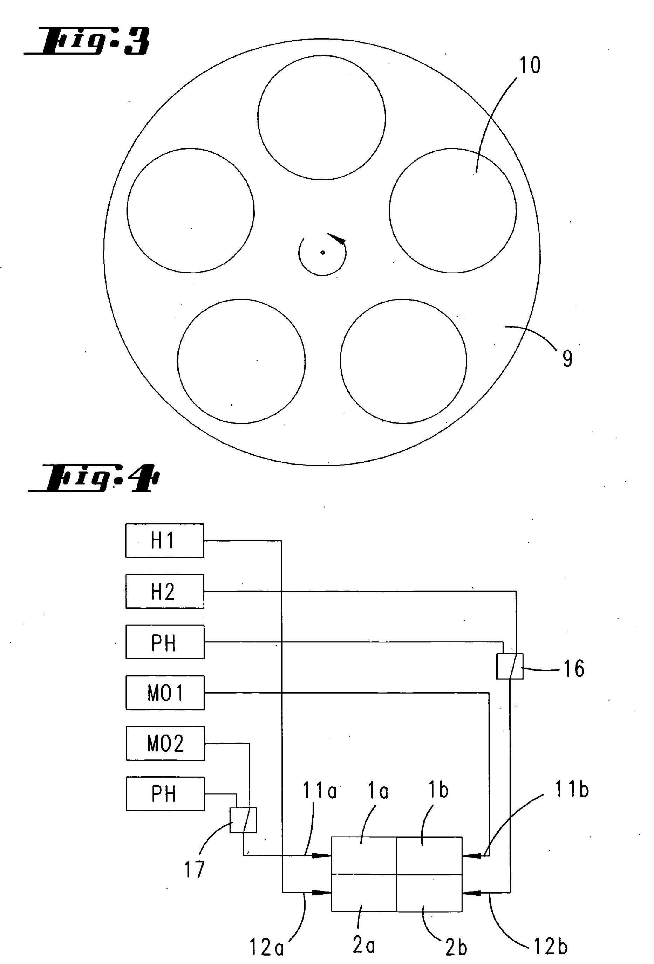

Ein CVD-Reaktor, in welchem die Gaseinlassorgane angeordnet sind, besitzt ein Gasmischsystem. Einige Bestandteile eines derartigen Gasmischsystems sind in der Fig. 4 dargestellt. Es handelt sich um die zur Erläuterung der Erfindung erforderlichen Komponenten. H₁ und H₂ sind Gasdosierungseinrichtungen für Hydride, beispielsweise NH₃, ASH₃ oder PH₃. Diese Dosiereinrichtungen H₁, H₂ bestehen aus Massenfluss-Controllern und Ventilen. Mit der Gasdosiereinrichtung H₁ wird ein Abteil 2b einer Kammer 2 eines Gaseinlassorgans mit einem Hydrid gespeist. Das von der Gasdosiereinrichtung H₂ gelieferte Hydrid kann bei einer entsprechenden Stellung des Umschaltventils 16 in das zweite Abteil 2a der Kammer 2 eingeleitet werden, so dass die gesamte Kammer 2 mit einem Hydrid gespeist wird. Mit MO₁ ist eine Gasdosiereinrichtung bezeichnet, welche ein Abteil 1b einer Kammer 1 mit einer metallorganischen Komponente speist. Mit MO₂ ist eine zweite Gasdosiereinrichtung bezeichnet, die bei einer entsprechenden Stellung des Umschaltventils 17 das zweite Abteil 1a der Kammer 1 mit einer metallorganischen Komponente speist. Bei dieser Betriebsart treten aus der Unterseite des Gaseinlassorgans im Wesentlichen an jeder Stelle beide Prozessgase aus. Die üblicherweise erforderlichen Vent-Leitungen sind der besseren Übersichtlichkeit halber nicht dargestellt.

Werden die Umschaltventile 16, 17 umgestellt, so fließt in das Abteil 2a der unteren Kammer nach wie vor das Hydrid, in das danebenliegende Abteil 2b jedoch das Spülgas, welches die Gasdosiereinrichtung PH bereitstellt. In die oberhalb des Abteils 2a angeordnete Abteil 1a fließt bei einer entsprechenden Stellung des Umschaltventils 17 das von der Gasdosiereinrichtung PMO bereitgestellte Spülgas, während in das dem Abteil 2a diagonal gegenüberliegende Abteil 1b die metallorganische Komponente einströmt. Dies hat zur Folge, dass in die Zone unterhalb des Gaseinlassorgans die den mit b bezeichneten Abteile zugeordnet ist, eine metallorganische Komponente einströmt und in die Umfangszone, die den Abteilen a zugeordnet ist, das Hydrid einströmt.

Ein Gasmischsystem für mehr als zwei Abteile in jeder Kammer sieht entsprechender Weise umfangreicher aus. Es besitzt entsprechend mehr Umschaltventile 16,17 und entsprechend mehr Gasdosiereinrichtungen vor.

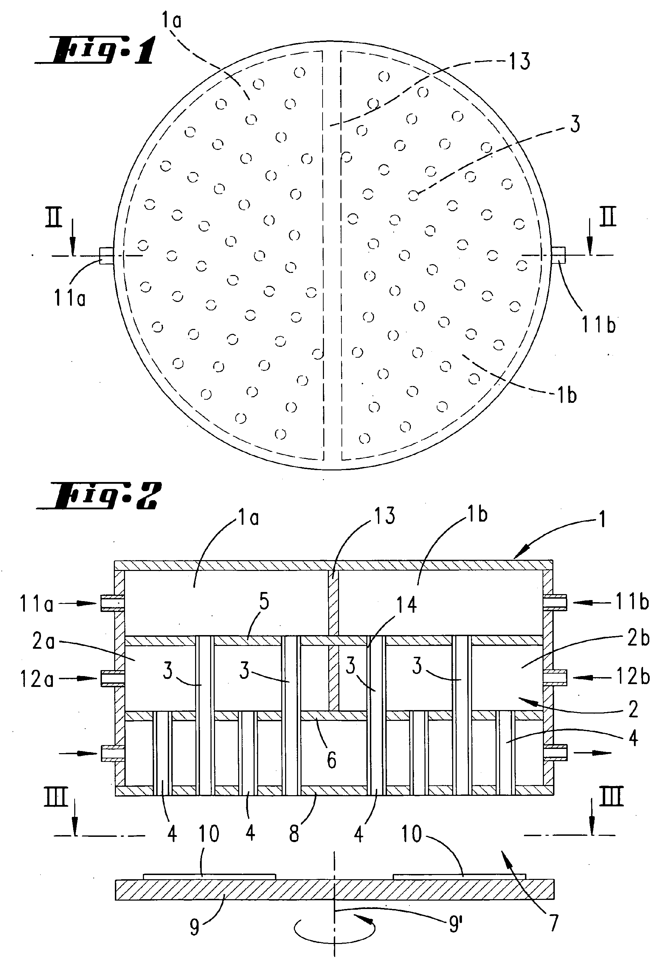

Das in den Figuren 1 und 2 dargestellte Gaseinlasssystem besteht im Wesentlichen aus einem Edelstahlgehäuse mit einer Deckenplatte, zwei Mittelplatten 5, 6 und einer Bodenplatte 8. Es sind übereinanderliegende Kammern 1, 2 ausgebildet, wobei die Kammer 1 zwei Abteile 1a und 1b ausbildet. Die Abteile 1a, 1b haben jeweils eine im Wesentlichen halbkreisförmige Querschnittsform und werden von einer Trennwand 13 gasdicht voneinander getrennt. In das Abteil 1a mündet eine Zuleitung ein 11a und in das Abteil 1 b eine Zuleitung 11b.

Die Bodenplatte 5 der Kammer 1 ist mit einer Vielzahl von Röhrchen mit der Bodenplatte 8, die die Unterseite des Gaseinlassorgans bildet, verbunden. Diese Röhrchen bilden Gasaustrittskanäle 3, durch welche das in die Kammer 1 eingebrachte Prozessgas oder Spülgas in die unterhalb des Gaseinlassorgans angeordnete Prozesskammer 7 strömen kann.

Unterhalb der Unterwandung 5 der oberen Kammer 1 befindet sich die zweite Kammer 2. Auch die zweite Kammer 2 ist mittels Röhrchen, die von der unteren Wandung 6 ausgehen, mit der Bodenplatte des Gaseinlassorgans verbunden, so dass sich Gasaustrittskanäle 4 ausbilden, durch welche das Prozess- oder Spül gas, welches in die Kammer 2 eingeleitet wird, in die Prozesskammer 7 strömen kann.

Die Prozesskammer 2 ist mittelst einer diagonal verlaufenden Trennwand 14 in zwei Abteile 2a, 2b aufgeteilt. Jedem Abteil 2a, 2b ist eine individuelle Gaszuleitung 12a, 12b zugeordnet, durch die entweder ein Prozessgas oder ein Spülgas in die Kammer 2a, 2b eingeleitet werden kann.

Unterhalb der beiden Kammern 1, 2 befindet sich eine dritte Kammer 15, die nicht unterteilt ist. Durch diese Kammer 15 ragen alle die Gasaustrittskanäle 3, 4 ausbildenden Röhrchen. Die Kammer 15 wird von einem Kühlmittel durchströmt, welches die Bodenplatte 8 des Gaseinlassorgans und die Röhrchen kühlt.

Unterhalb der Unterseite des Gaseinlassorgans 8 befindet sich ein beispielsweise aus Graphit gefertigter Substrathalter 9. Der Substrathalter 9 liegt im Wesentlichen deckungsgleich unterhalb des Gaseinlassorgans und besitzt ebenfalls eine Kreisscheibenform. Mittelst eines nicht dargestellten Antriebsorgans kann der Substrathalter 9 um seine Achse 9' gedreht werden. Die sich in ringförmiger Anordnung auf dem Substrathalter 9 befindenden Substrate 10 werden dann unter der Gasaustrittsfläche des Gaseinlassorgans gedreht.

Wird beispielsweise das Abteil 2a mit einem Hydrid, das danebenliegende Abteil 2b mit einem Spülgas, das diagonal oberhalb des Abteils 2a angeordnete Abteil 1b mit einer metallorganischen Verbindung und das danebenliegende Abteil 1a wiederum mit einem Spülgas gespeist, so treten aus der Gasauslassfläche des Gaseinlassorgans in unterschiedlichen Zonen verschiedene Prozessgase in die Prozesskammer 7 ein. In einer sich etwa über 180° erstreckenden Umfangszone unterhalb des Abteils 2a tritt das Hydrid in die Prozesskammer. In der danebenliegenden ebenfalls sich etwa über 180° erstreckenden Umfangszone tritt die metallorganische Komponente in die Prozesskammer ein. Zwischen den beiden Zonen kann über nicht dargestellte Spüleinlasskanäle ein Spülgas eingeleitet werden. Wird bei dieser Betriebsweise des Reaktors der Substrathalter 9 gedreht, so werden die darauf aufliegenden Substrate 10 zeitlich abwechselnd dem einen oder dem anderen Prozessgas ausgesetzt.

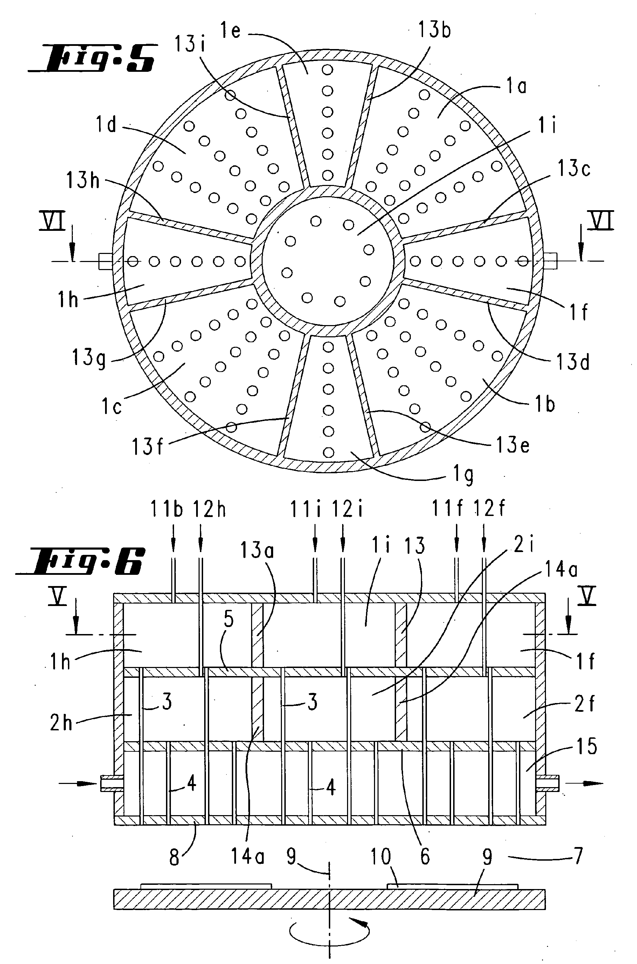

Bei dem in den Figuren 5 und 6 dargestellten Ausführungsbeispiel eines Gaseinlassorgans besitzt jede Kammer 1, 2 insgesamt 9 Abteile 1a - 1i und 2a - 2i.

Auch bei diesem Ausführungsbeispiel liegen die die einzelnen Abteile 1a - 1i, 2a - 2i trennenden Trennwände 13a - 13i und 14a - 14i fluchtend übereinander.

Jede der beiden übereinanderliegenden Kammern 1, 2 besitzt ein zentrales Abteil 1i, 2i. Das zentrale Abteil 1i, 2i ist von einer ringförmigen Wandung 13a umgeben. Dieses zentrale Abteil 1i, 2i kann entweder mit dem der Kammer 1, 2 zugeordneten Prozessgas oder mit einem Spülgas gespeist werden, so dass sich ein zentraler gespülter und prozessgasfreier Raum in der Prozesskammer 7 einstellt.

Das zentrale Abteil 1i, 2i ist mit einer Vielzahl von speichenartig verlaufenden Trennwände 13b - 13i bzw. 14b - 14i umgeben. Diese Trennwände 13b -13i, 14b - 14i verlaufen auf Diagonalen. Von ihnen werden in Umfangsrichtung hintereinander angeordnete Abteile 1a - 1h bzw. 2a - 2h gebildet. Dabei werden Abteile 1a, 1b, 1c, 1d gebildet, die sich über einen größeren Umfangswinkel erstrecken. Die Kammer 2 bildet entsprechend und deckungsgleich dazu liegende Kammern 2a - 2d aus. Durch diese, kreuzförmig angeordneten Abteile 1a - 1d bzw. 2a - 2d können die Prozessgase in die Prozesskammer 7 eingeleitet werden. Dies erfolgt auch wieder wechselsinnig, so dass beispielsweise die sich gegenüberliegenden Abteile 1a und 1c mit einer metallorganischen Verbindung gespeist werden. Die um 90° versetzte dazu liegenden Abteile 1b und 1d werden dagegen mit einem Spülgas gespeist. Bei der Kammer 2 werden die Abteile 2a und 2c mit einem Spülgas gespeist. Die unter den gespülten Abteilen 1b und 1d angeordneten Abteile 2b und 2d der unteren Kammern werden mit Hydrid gespeist.

Zwischen den sich über einen größeren Umfangswinkel erstreckenden Abteile 1a - 1d bzw. 2a - 2d sind Spülgasabteile 1e -1h bzw. 2e - 2h angeordnet. Diese Abteile 1e -1h bzw. 2e - 2h können wahlweise mit dem der jeweiligen Kammer 1, 2 zugeordneten Prozessgas oder einem Spülgas gespeist werden.

Mit dem in den Figuren 5 und 6 dargestellten Gaseinlassorgan können bei einer entsprechenden Speisung der Abteile alle Prozessgase in Mischung in die Prozesskammer 7 eingeleitet werden. Bei einer davon abweichenden Schaltstellung des Gasmischsystems werden aber nur eine Auswahl der Abteile mit dem Prozessgas gespeist, wobei die nicht ausgewählten Abteile mit einem Spülgas gespeist werden, so dass sich in der Prozesskammer 7 Umfangsbereiche einstellen, in denen das Substrat einem Hydrid oder einer metallorganischen Verbindung ausgesetzt wird.

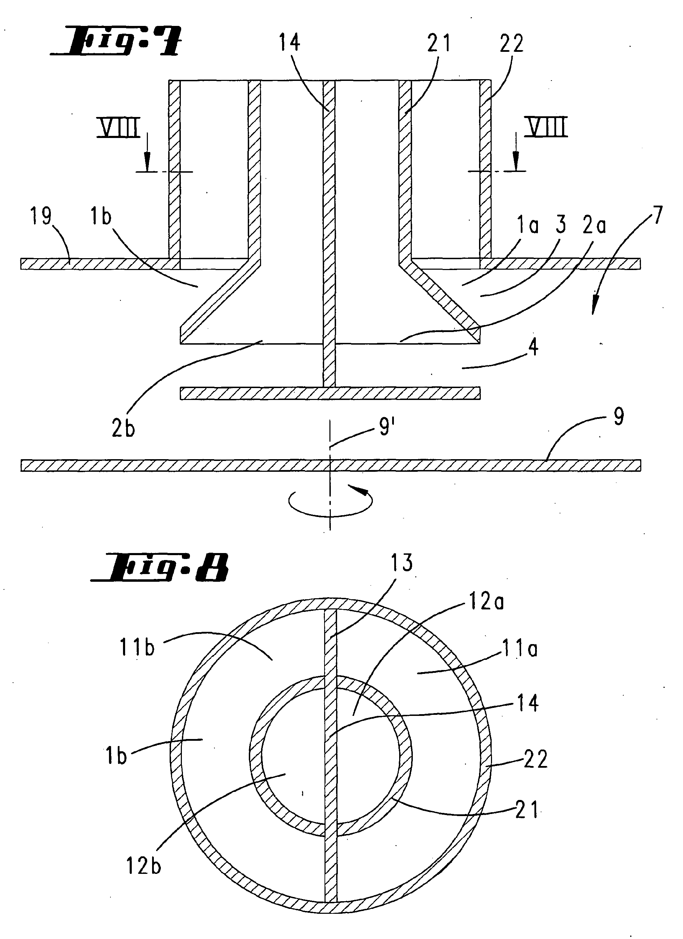

Bei dem in den Figuren 7 und 8 dargestellten weiteren Ausführungsbeispiel handelt es sich um einen so genannten Planetenreaktor, bei dem das Gaseinlassorgan im Zentrum einer Prozesskammer 7 sitzt. Die Prozesskammer besitzt eine Prozesskammerdecke 19, die eine zentrale Öffnung aufweist, durch die das insbesondere wassergekühlte Gaseinlassorgan in die Prozesskammer hineinragt. Unterhalb des Gaseinlassorgans und der Prozesskammerdecke 19 befindet sich der Boden 9 der Prozesskammer, der von einem Substrathalter gebildet ist, der um seine zentrale Achse 9' drehangetrieben wird. Auf dem das Gaseinlassorgan umgebenden Bereich des Substrathalters 9 liegen eine Vielzahl von Substraten. Die Substrate können wiederum auf einzelnen Suszeptoren aufliegen, die mit geeigneten Mitteln drehangetrieben werden. Das aus dem Gaseinlassorgan herausströmende Gas durchströmt die Prozesskammer 7 in Radialrichtung.

Die Zeichnungen geben das Gaseinlassorgan nur schematisch wieder. Wesentlich ist, dass unterschiedliche Prozessgase, beispielsweise ein Hydrid oder eine metallorganische Verbindung durch Gaszuleitungen in Vertikalrichtung das Gaseinlassorgan durchströmen. Hierzu besitzt das Gaseinlassorgan ein äußeres Rohr 17, in welchem ein durchmesserkleineres Rohr 21 liegt. Die sich dadurch bildenden Lumen sind jeweils über diagonal verlaufende Trennwände 13,14 in Zuleitungen 11a, 11b bzw. 12a, 12b getrennt. Durch die äußeren Zuleitungen 11a, 11b strömt eine metallorganische Verbindung in eine erste Kammer 1a, 1b. Die Kammer bildet zwei sich über einen Halbkreis erstreckende, in einer gemeinsamen Horizontalebene liegende Abteile 1a, 1b aus. Die Abteile bilden die Endzonen der Zuleitungen 11a, 11b.

Das innere Rohr 21 bildet ebenfalls sich über eine Halbkreiszone erstreckende, in einer gemeinsamen Horizontalebene liegende Abteile 2a, 2b aus, die im Wesentlichen die Endabschnitte der Zuleitungen 12a, 12b sind.

Wie der Querschnittszeichnung in Fig. 7 zu entnehmen ist, liegt das Abteil 1a vertikal oberhalb des Abteils 2a. Das Abteil 1b liegt vertikal oberhalb des Abteils 2b. Das zentrale Rohr 21 weitet sich zu seinem in die Prozesskammer 7 ragenden Ende kegelförmig auf und bildet so eine Trennwand zwischen den Abteilen 1a, 2a bzw. 1b, 2b.

Die Abteile 1a, 1b besitzen über eine 180° Umfangsfläche sich erstreckende Austrittsöffnungen 3. Diese, jeweils voneinander wegweisende Austrittsöffnungen 3 dienen dem Austritt eines mit einem Trägergas transportierten metallorganischen Prozessgases in die Prozesskammer 7. Durch die darunter liegenden, ebenfalls sich über eine 180° Kreisumfangsfläche erstreckenden Austrittsöffnungen 4 der Abteile 2a, 2b treten die Hydride in die Prozesskammer ein.

Der Betrieb dieses Ausführungsbeispiels entspricht dem Betrieb der zuvor erörterten Ausführungsbeispiele. Es ist möglich, in die Abteile 2a, 2b bzw. 1a, 1b jeweils gleiche Prozessgase einzuleiten. Alternativ dazu kann lediglich in die Abteile 1a bzw. 2b ein Prozessgas eingeleitet werden. In die Abteile 1b und 2a wird dann lediglich ein Inertgas eingeleitet.

Wenn sich der Substrathalter 9 um seine Achse 9' dreht, treten die darauf liegenden Substrate abwechselnd in eine Gasphase ein, die das eine oder das andere Prozessgas enthält.

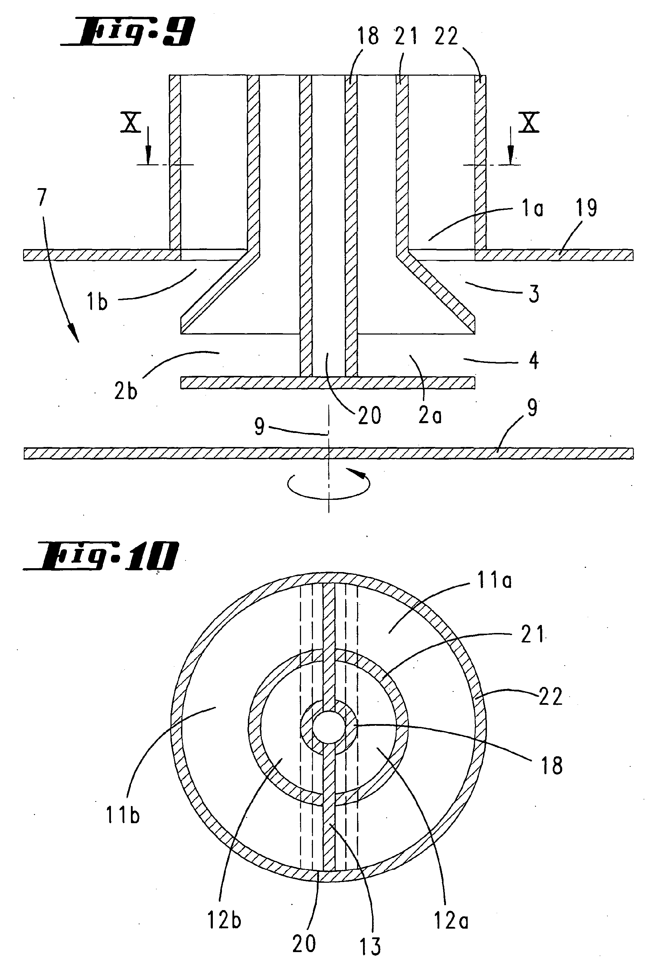

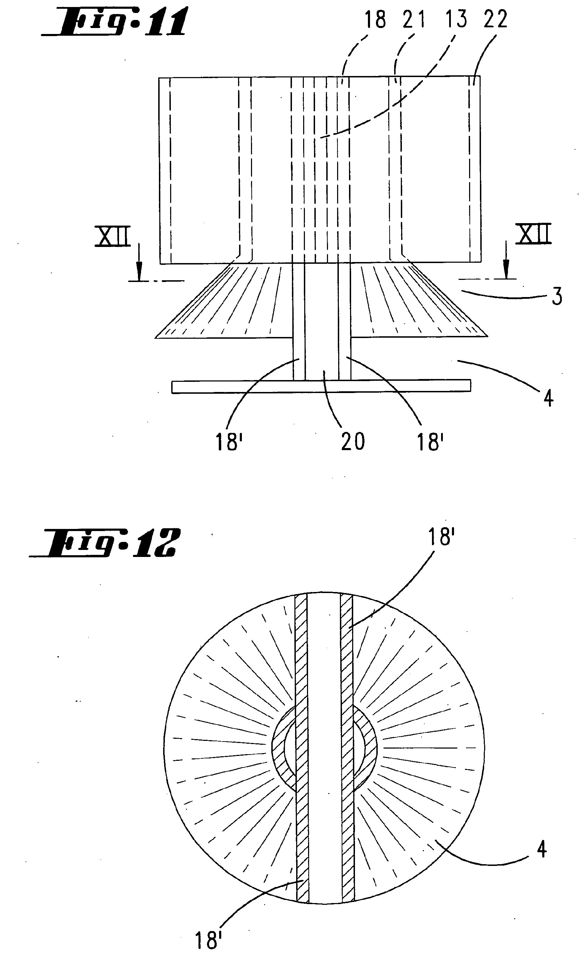

Das in den Figuren 9 bis 12 dargestellte Ausführungsbeispiel ist eine Variante des in den Figuren 7 und 8 dargestellten Ausführungsbeispiels. Auch hier tritt das Prozessgas in Horizontalrichtung aus den Abteilen 1a, 1b, 2a, 2b aus. Anders als bei dem zuvor beschriebenen Ausführungsbeispiel sind hier jedoch die Austrittsöffnungen 3, 4 der einzelnen Abteile 1a, 1b, bzw. 2a, 2b von einer Spülgasaustrittsöffnung 20 getrennt. Das Spülgas wird mittelst eines zentralen Rohres 18 eingeleitet. Das Spülgasrohr 18 befindet sich im Zentrum der Trennwand 14. Im Endbereich des Gaseinlassorgans weitet sich das Spülgasrohr 18 auf, so dass das Spülgas aus sich diametral gegenüberliegenden Austrittsöffnungen 20 in die Prozesskammer hineinströmen kann.

In einem nicht dargestellten Ausführungsbeispiel kann zusätzlich eine zentrale Prozessgasleitung vorgesehen sein, die in der Stirnfläche des Gaseinlassorgans mündet, wie es bei dem eingangs genannten Stand der Technik der Fall ist. Durch diese zentrale Spülgasleitung kann beispielsweise das Hydrid in die Prozesskammer geleitet werden, wie es beim Stand der Technik der Fall ist. Durch die sich über verschiedene Umfangswinkel erstreckende Abteile können dann unterschiedliche metallorganische Verbindungen in die Prozesskammer eingeleitet werden; so können beispielsweise indiumhaltige oder galliumhaltige metallorganische Verbindungen in unterschiedliche Segmente der Prozesskammer eingeleitet werden. Das Hydrid wird dann aber in jede Richtung, also über 360° in die Prozesskammer eingeleitet.

## Patentansprüche

1. Verfahren zum Beschichten ein oder mehrerer Substrate mit einer Schicht, deren Komponenten in Form mindestens zweier Gase mittelst eines Gaseinlassorgans in eine Prozesskammer (7) eingeleitet werden, wobei die Gase jeweils in übereinander angeordnete Kammern (1, 2) des Gaseinlassorgans eingebracht werden und von dort durch Gasaustrittsöffnungen (3, 4), die in die Prozesskammer (7) münden, in die Prozesskammer (7) eintreten, **dadurch gekennzeichnet, dass** zufolge einer Aufteilung jeder der beiden Kammern in je mindestens zwei Abteile (1a,1b; 2a, 2b), die im Wesentlichen deckungsgleich übereinanderliegen, die beiden Prozessgase in Umfangsrichtung getrennt voneinander in die Prozesskammer eintreten, so dass die in ringförmiger Anordnung auf einem den Boden der Prozesskammer (7) bildenden Substrathalter (9) liegenden Substrate (10) zufolge einer Drehung des Substrathalters (9) um seine Achse (9') nacheinander den verschiedenen Prozessgasen ausgesetzt sind.

2. Verfahren nach Anspruch 1, **dadurch gekennzeichnet, dass** jeweils nur nicht übereinander angeordnete Abteile (1a, 2b) mit einem Prozessgas und die anderen Abteile (1b, 2a) mit einem Spülgas gespeist werden.

3. Verfahren nach einem der vorhergehenden Ansprüche, **dadurch gekennzeichnet, dass** in Umfangsrichtung zwischen den mit Prozessgasen gespeisten Abteilen (1a, 2b, 1c, 2d) Abteile (1e, 1f, 1g, 1h) angeordnet sind, die mit einem Spülgas gespeist werden, zum Austritt des Spülgases aus der Unterseite des Gaseinlassorgans.

4. Gaseinlassorgan eines CVD-Reaktors mit mindestens zwei übereinander angeordnete Kammern (1, 2) von deren unteren Wandung (5,6) jeweils Gasaustrittsöffnungen (3, 4) ausgehen, die in die Prozesskammer (7) münden zur Zuleitung je eines mittels einer Zuleitung (11,12) in die Kammern (1, 2) gebrachten Prozessgases in die Prozesskammer (7), deren Boden von einem drehantreibbaren Substrathalter (9) gebildet ist, **dadurch gekennzeichnet, dass** jede der mindestens beiden Kammern (1, 2) in je mindestens zwei Abteile (1a, 1b; 2a, 2b) geteilt sind, und die Abteile (1a, 1b; 2a, 2b) der verschiedenen Kammern (1, 2) im Wesentlichen deckungsgleich übereinanderliegen und jeweils zugeordnete Zuleitungen (1a, 11b; 12a, 12b) aufweisen.

5. Gaseinlassorgan nach Anspruch 4, **gekennzeichnet durch** im Bereich der Trennzone zwischen den Abteilen (1a, 1b; 2a, 2b) angeordnete Spülgasaustrittsöffnungen.

6. Gaseinlassorgan nach einem der vorhergehenden Ansprüche, **dadurch gekennzeichnet, dass** die Substrate (10) ringförmig um das Zentrum (9') des rotationssymmetrischen Substrathalters (9) angeordnet sind.

7. Gaseinlassorgan nach einem der vorhergehenden Ansprüche, **gekennzeichnet durch** eine stern- oder kreuzförmige Teilung der Kammern (1, 2) in eine Vielzahl von Abteilen (1a - 1i; 2a - 2i).

8. Gaseinlassorgan nach einem der vorhergehenden Ansprüche, **gekennzeichnet durch** ein zentrales Abteil (1i, 2i) zum Einleiten wahlweise eines Prozessgases oder eines Spülgases.

9. Gaseinlassorgan nach einem der vorhergehenden Ansprüche, **gekennzeichnet durch** eine Vielzahl von in Umfangsrichtung verteilt angeordnete Abteile (1a - 1h; 2a - 2h) zur Zuleitung entweder eines Spülgases oder eines Prozessgases in die Prozesskammer (7).

10. Gaseinlassorgan nach einem der vorhergehenden Ansprüche, **dadurch gekennzeichnet, dass** die die Abteile (1a - 1i; 2a - 2i) gasdicht voneinander trennende Trennwände (13,14) fluchtend übereinander angeordnet sind.

11. Gaseinlassorgan nach einem der vorhergehenden Ansprüche, **gekennzeichnet durch** eine unterhalb der Kammern (1, 2) angeordnete Kühlmittelkammer (15), deren Boden (8) die Unterseite des Gaseinlassorgans ausbildet.

12. Gaseinlassorgan nach einem der vorhergehenden Ansprüche, **dadurch gekennzeichnet, dass** die Gasaustrittsöffnungen (3, 4) Kanäle sind, die in einer die Decke der Prozesskammer (7) bildenden Unterseite (8) des Gasauslassorgans münden.

13. Gaseinlassorgan eines CVD-Reaktors mit mindestens zwei übereinander angeordneten, von Umfangsöffnungen des Gaseinlassorgans gebildeten Gasaustrittsöffnungen (3, 4), die in die Prozesskammer (7) münden zur Zuleitung je eines mittels einer Zuleitung (11a, 11b, 12a, 12b) zur Gasaustrittsöffnung (3, 4) gebrachten Prozessgases, wobei der Boden der Prozesskammer (7) von einem drehantreibbaren Substrathalter (9) gebildet ist, **dadurch gekennzeichnet, dass** jede der mindestens beiden Gasaustrittsöffnungen (3, 4) in je mindestens zwei Abteile (1a, 1b; 2a, 2b) geteilt sind, und die Abteile (1a, 1b; 2a, 2b) der verschiedenen Gasaustrittsöffnungen (3, 4) im Wesentlichen deckungsgleich übereinanderliegen und jeweils zugeordnete Zuleitungen (11a, 11b; 12a, 12b) aufweisen.

14. Gaseinlassorgan nach einem der vorhergehenden Ansprüche, **dadurch gekennzeichnet, dass** zwischen den Gasaustrittsöffnungen (3, 4) der Abteile (1a, 1b, 2a, 2b) Austrittsöffnungen (20) einer Spülgasleitung (18) angeordnet sind.

15. Gaseinlassorgan nach einem der vorhergehenden Ansprüche, **gekennzeichnet durch** eine Gasmischeinrichtung mit ersten Gasdosiereinrichtungen (H₁, H₂) für ein erstes Prozessgas und zweite Gasdosiereinrichtungen (MO₁, MO₂) für ein zweites Prozessgas, und eine Umschaltventilanordnung (16, 17), mit der entweder alle Abteile (1a - 1i; 2a - 2i) einer jeden Kammer (1, 2) mit demselben Prozessgas versorgt werden oder nur jeweils eine Auswahl nicht übereinanderliegender Abteile (1a - 1i; 2a - 2i) mit dem zugeordneten Prozessgas versorgt werden.

16. CVD-Reaktor mit einem Gaseinlassorgan nach einem der vorhergehenden Ansprüche und einer Gasmischanordnung zur wahlweisen Speisung entweder aller Abteile (1a - 1i; 2a - 2i) einer jeden Kammer (1, 2) mit demselben Prozessgas oder nur jeweils einer Auswahl nicht übereinanderliegender Abteile (1a - 1i; 2a - 2i) mit dem der jeweiligen Kammer zugeordneten Prozessgas und einem unterhalb des Gaseinlassorgans angeordneten Substrathalter (9), der um eine zentrale Achse drehbar ist.

## Claims

1. A method for coating one or more substrates with a layer, the constituents of the layer being fed into a process chamber (7) in the form of at least two gases by means of a gas inlet element, the gases being introduced in each case into chambers (1, 2) of the gas inlet element that are disposed one above the other and from there entering the process chamber (7) through gas outlet openings (3, 4), which open out into the process chamber (7), **characterized in that** as a result of dividing each of the two chambers into in each case at least two compartments (1a, 1b; 2a, 2b), the compartments being located one above the other in a substantially congruent manner, the two process gases enter the process chamber separated from one another in the circumferential direction, so that the substrates (10), which lie in an annular arrangement on a substrate holder (9) that forms the bottom of the process chamber (7), are exposed to the different process gases one after the other as a result of rotation of the substrate holder (9) about its axis (9').

2. A method according to Claim 1, **characterized in that** in each case only compartments (1a, 2b) that are not disposed one above the other are fed with a process gas and the other compartments (1b, 2a) are fed with a purge gas.

3. A method according to either of the preceding claims, **characterized in that** compartments (1e, 1f, 1g, 1h) are disposed in the circumferential direction between the compartments (1a, 2b, 1c, 2d) that are fed with process gases, the compartments (1e, 1f, 1g, 1h) being fed with a purge gas, for exit of the purge gas from the underside of the gas inlet element.

4. A gas inlet element for a CVD reactor, the element having at least two chambers (1, 2) disposed one above the other, gas outlet openings (3, 4) starting in each case from the lower wall (5, 6) of the chambers, the openings opening out into the process chamber (7) for supply, into the process chamber (7), of a process gas brought in each case into the chambers (1, 2) by means of a feed line (11, 12), the bottom of the process chamber being formed by a substrate holder (9) that can be driven in rotation, **characterized in that** each of the at least two chambers (1, 2) is divided in each case into at least two compartments (1a, 1b; 2a, 2b), and the compartments (1a, 1b; 2a, 2b) of the individual chambers (1, 2) are located one above the other in a substantially congruent manner and in each case have associated supply lines (11a, 11b; 12a, 12b).

5. A gas inlet element according to Claim 4, **characterized by** purge gas outlet openings disposed between the compartments (1a, 1b; 2a, 2b) in the region of the partition zone.

6. A gas inlet element according to any of the preceding claims, **characterized in that** the substrates (10) are disposed in an annular manner about the centre (9') of the rotationally symmetrical substrate holder (9).

7. A gas inlet element according to any of the preceding claims, **characterized by** a star-shaped or cross-shaped division of the chambers (1, 2) into a plurality of compartments (1a-1i; 2a-2i).

8. A gas inlet element according to any of the preceding claims, **characterized by** a central compartment (1i, 2i) for selective introduction of a process gas or a purge gas.

9. A gas inlet element according to any of the preceding claims, **characterized by** a plurality of compartments (1a-1h; 2a-h) arranged in a distributed manner in the circumferential direction for supply into the process chamber (7) either of a purge gas or a process gas.

10. A gas inlet element according to any of the preceding claims, **characterized in that** the partition walls (13, 14), which separate the compartments (1a-1i; 2a-i) from one another in a gas-tight manner, are arranged aligned one above the other.

11. A gas inlet element according to any of the preceding claims, **characterized by** a chamber (15) for a cooling medium, which is disposed underneath the chambers (1,2), and the bottom (8) of which forms the underside of the gas inlet element.

12. A gas inlet element according to any of the preceding claims, **characterized in that** the gas outlet openings (3, 4) are passages, which open out into the underside (8) of the gas inlet element, this underside forming the top of the process chamber (7).

13. A gas inlet element for a CVD reactor, the element having at least two gas outlet openings (3, 4), disposed one above the other and formed by circumferential openings in the gas inlet element, the openings opening out into the process chamber (7) for supply of in each case a process gas brought to the gas outlet opening (3, 4) by means of a feed line (11a, 11b, 12a, 12b), the bottom of the process chamber (7) being formed by a substrate holder (9) that can be driven in rotation, **characterized in that** each of the at least two gas outlet openings (3, 4) is divided in each case into at least two compartments (1a, 1b; 2a, 2b), and the compartments (1a, 1b; 2a, 2b) of the individual gas outlet openings (3, 4) are located one above the other in a substantially congruent manner and in each case have associated supply lines (11a, 11b; 12a, 12b).

14. A gas inlet element according to any of the preceding claims, **characterized in that** outlet openings (20) for a purge gas line (18) are disposed between the gas outlet openings (3, 4) of the compartments (1a, 1b, 2a, 2b).

15. A gas inlet element according to any of the preceding claims, **characterized by** a gas mixing device comprising first gas metering devices (H₁, H₂) for a first process gas and second gas metering devices (MO₁, MO₂) for a second process gas, and a changeover valve arrangement (16, 17), by means of which all compartments (1a-1i; 2a-2i) of either chamber (1, 2) are supplied with the same process gas or only in each case a selection of compartments (1a-1i; 2a-2i) that are not located one above the other are fed with the assigned process gas.

16. A CVD reactor comprising a gas inlet element according to any of the preceding claims and a gas mixing arrangement for selective supply either of all compartments (1a-1i; 2a-2i) of either chamber (1, 2) with the same process gas or only in each case a selection of compartments (1a-1i; 2a-2i) that are not located one above the other with the process gas assigned to the respective chamber, and comprising a substrate holder (9), which is disposed underneath the gas inlet element and is rotatable about a central axis.

## Revendications

1. Procédé de revêtement d'un ou plusieurs substrats avec une couche dont les composants sont introduits dans une chambre de réaction (7) sous la forme d'au moins deux gaz au moyen d'un organe d'admission de gaz, les gaz étant introduits respectivement dans des chambres (1, 2), disposées l'une au-dessus de l'autre, de l'organe d'admission de gaz puis pénétrant dans la chambre de réaction (7) par des ouvertures de sortie de gaz (3, 4) qui débouchent dans la chambre de réaction (7), **caractérisé en ce que**, comme chacune des deux chambres est divisées en au moins deux compartiments (1a, 1b ; 2a, 2b) qui sont disposés l'une au-dessus de l'autre sensiblement de façon à coïncider, les deux gaz de réaction entrent séparément dans la chambre de réaction dans une direction périphérique de sorte que les substrats (10), disposés annulairement sur un porte-substrat (9) formant le fond de la chambre de réaction (7), sont soumis successivement, autour de l'axe (9') dudit porte-substrat, aux différents gaz de réaction.

2. Procédé selon la revendication 1, **caractérisé en ce que** seuls les compartiments (1a, 2b) qui ne sont pas disposés l'un au-dessus de l'autre sont alimentés avec un gaz de réaction et **en ce que** les autres compartiments (1b, 2a) sont alimentés avec un gaz de lavage.

3. Procédé selon l'une des revendications précédentes, **caractérisé en ce que** des compartiments (1e, 1f, 1g , 1h), qui sont alimentés avec un gaz de lavage, sont disposés dans une direction périphérique entre les compartiments (1a, 2b, 1c, 2d), alimentés avec des gaz de réaction, pour permettre la sortie du gaz de lavage du côté inférieur de l'organe d'admission de gaz.

4. Organe d'admission de gaz d'un réacteur CVD, comportant au moins deux chambres (1, 2) disposées l'une au-dessus de l'autre dans la paroi inférieure (5, 6) desquelles sont ménagées des ouvertures de sortie de gaz (3, 4) qui débouchent dans la chambre de réaction (7) afin d'amener un gaz de réaction, introduit dans les chambres (1, 2) à chaque fois au moyen d'une conduite d'amenée (11, 12), dans la chambre de réaction (7) dont le fond est formé par un porte-substrat (9) pouvant être entraîné en rotation, **caractérisé en ce que** chacune des moins deux chambres (1, 2) est divisée en au moins deux compartiments (1a, 1b ; 2a, 2b), et **en ce que** les compartiments (1a, 1b ; 2a, 2b) des différentes chambres (1, 2) sont disposés l'un au dessus de l'autre de façon à sensiblement coïncider et comportent chacun des conduites d'amenée associées (11a, 11b ; 12a, 12b).

5. Organe d'admission de gaz selon la revendication 4, **caractérisé par** des ouvertures de sortie de gaz de lavage ménagées dans la région de la zone de séparation entre les compartiments (1a, 1b ; 2a, 2b).

6. Organe d'admission de gaz selon l'une des revendications précédentes, **caractérisé en ce que** les substrats (10) sont disposés annulairement autour du centre (9') du porte-substrat (9) à symétrie de révolution.

7. Organe d'admission de gaz selon l'une des revendications précédentes, **caractérisé en ce que** les chambres (1, 2) sont divisées, en étoile ou en croix, en un grand nombre de compartiments (1a-1i ; 2a-2i).

8. Organe d'admission de gaz selon l'une des revendications précédentes, **caractérisé par** un compartiment central (1i, 2i) permettant d'introduire au choix un gaz de réaction ou un gaz de lavage.

9. Organe d'admission de gaz selon l'une des revendications précédentes, **caractérisé par** un grand nombre de compartiments (1a-1li ; 2a-2i) répartis dans la direction périphérique et destinés à amener soit un gaz de lavage soit un gaz de réaction dans la chambre de réaction (7).

10. Organe d'admission de gaz selon l'une des revendications précédentes, **caractérisé en ce que** les parois de séparation (13, 14), séparant les compartiments (1a-1i ; 2a-2i) l'un de l'autre de façon étanche aux gaz, sont disposées de façon alignée l'une au-dessus de l'autre.

11. Organe d'admission de gaz selon l'une des revendications précédentes, **caractérisé par** une chambre d'agent de refroidissement (15) qui est disposée au-dessous des chambres (1, 2) et dont le fond constitue le côté inférieur de l'organe d'admission de gaz.

12. Organe d'admission de gaz selon l'une des revendications précédentes, **caractérisé en ce que** les ouvertures de sortie de gaz (3, 4) sont des canaux qui débouchent dans un côté inférieur (8), formant le plafond de la chambre de réaction (7), de l'organe d'admission de gaz.

13. Organe d'admission de gaz d'un réacteur CVD, comportant au moins deux ouvertures de sortie de gaz (3, 4) qui sont disposées l'une au-dessus de l'autre, qui sont formées par des ouvertures périphériques de l'organe de l'admission de gaz et qui débouchent dans la chambre de réaction (7) pour amener chacune un gaz de réaction amené à l'ouverture de sortie de gaz (3, 4) au moyen d'une conduite d'amenée (11a, 11b, 12a, 12b), le fond de la chambre de réaction (7) étant formé par un porte-substrat (9) pouvant être entraîné en rotation, **caractérisé en ce que** chacune des au moins deux ouvertures de sortie de gaz (3, 4) est divisée en au moins deux compartiments (1a, 1b ; 2a, 2b) et les compartiments (1a, 1b ; 2a, 2b) des différentes ouvertures de sortie de gaz (3, 4) comportent des conduites d'amenée (11a, 11b ; 12a, 12b) qui sont respectivement associées et qui sont disposées l'une au-dessus de l'autre sensiblement de façon à coïncider.

14. Organe d'admission de gaz selon l'une des revendications précédentes, **caractérisé en ce que** des ouvertures de sortie (20) d'une conduite de gaz de lavage (18) sont ménagées entre les ouvertures de sortie de gaz (3, 4) des compartiments (1a, 1b, 2a, 2b).

15. Organe d'admission de gaz selon l'une des revendications précédentes, **caractérisé par** un dispositif de mélange de gaz comportant des premiers dispositifs de dosage de gaz (H₁, H₂) destinés à un premier gaz de réaction et des seconds dispositifs de dosage de gaz (MO₁, MO₂) destinés à un second gaz de réaction, et par un système de soupapes commutable (16, 17) au moyen duquel tous les compartiments (1a-1i ; 2a-2i) de chaque chambre (1, 2) sont alimentés avec le même gaz de réaction ou bien seule une sélection de compartiments (1a-1i ; 2a-2i) qui ne sont pas disposés l'un au-dessus de l'autre sont alimentés avec le gaz de réaction associé.

16. Réacteur CVD comportant un organe d'admission de gaz selon l'une des revendications précédentes et un dispositif de mélange de gaz destiné à alimenter au choix tous les compartiments (1a-1i ; 2a-2i) d'une chambre (1, 2) avec le même gaz de réaction ou bien seulement une sélection de compartiments (1a-1i ; 2a-2i), qui ne sont pas disposés l'un au-dessus de l'autre, avec le gaz de réaction associé à la chambre respective et un porte-substrat (9) disposé au-dessous de l'organe d'admission de gaz et apte à tourner autour d'un axe central.
